# EUROPEAN PATENT SPECIFICATION

(11) **EP 2 720 254 B1**
(45) Date of publication and mention of the grant of the patent: **24.04.2019**
(21) Application number: 11867376.3
(22) Date of filing: 08.06.2011
(51) Int. Cl.: H01L 21/322, H01L 21/328, H01L 29/32, H01L 29/739

(54) **SEMICONDUCTOR DEVICE AND METHOD FOR PRODUCING SAME**
HALBLEITERVORRICHTUNG UND HERSTELLUNGSVERFAHREN DAFÜR
DISPOSITIF SEMI-CONDUCTEUR ET SON PROCÉDÉ DE FABRICATION

(43) Date of publication of application: 16.04.2014
(73) Proprietor: TOYOTA JIDOSHA KABUSHIKI KAISHA, Toyota-shi, Aichi-ken, 471-8571 (JP)
(72) Inventor: SOENO, Akitaka, Toyota-shi Aichi-ken, 471-8571 (JP)
(74) Representative: Desormiere, Pierre-Louis
(86) International application number: PCT/JP2011/063137
(87) International publication number: WO 2012/169022

(56) References cited:
- EP-A1- 0 430 237
- EP-A1- 0 862 220
- EP-A1- 1 014 453
- WO-A1-2007/055352
- WO-A1-2011/049054
- JP-A- 2001 077 357
- JP-A- 2002 093 813
- JP-A- 2008 135 439
- JP-A- 2008 171 952
- US-A1- 2005 258 493
- US-A1- 2009 224 284
- US-B1- 6 261 874

## Description

### Technical Field

The techniques described in the present description relate to a semiconductor device and to a method of manufacturing the semiconductor device.

### Background Art

It is common practice to form crystal defects by irradiating a part of a semiconductor substrate with charged particles for the purpose of controlling a lifetime of carriers. For example, Japanese Patent Application Publication No. 2005-317751 (Patent Document 1) discloses a semiconductor device comprising a semiconductor substrate in which a diode and an IGBT are formed, wherein crystal defects are formed in a region near a bottom surface of a trench gate of a drift layer of the semiconductor substrate. European Patent Application Publications EP 0 430 237 A1 and EP 0 862 220 A1 disclose the formation of the life control region by irradiating charged particles (protons in the first and He2+ in the second document) in the highly doped N + buffer region of vertical IGBT devices to avoid deterioration of the withstand device. United States Patent Application Publication US 2009/224284 A1 discloses the formation of the life control region by irradiating protons and subsequent anneal in a medial part of the drift region of a PN junction diode.

### Citation List

### Patent Literature

Patent Document 1: Japanese Patent Application Publication No. 2005-317751
Patent Document D2: EP 0430237 A1
Patent Document D3: EP 0862220 A1
Patent Document D4: US2009/224284 A1.

### Summary of Invention

### Technical Problem

Normally, crystal defects are formed by irradiating a semiconductor substrate with charged particles. As the charged particles travel through and stop inside the semiconductor substrate, a local defect region with a high crystal defect density is formed near a position where the charged particles had stopped. The local defect region functions effectively as a lifetime control region. At the same time, the crystal defects are also formed in a region through which the charged particles had passed through. A resistivity of a region in which the crystal defects are formed by the charged particles increases from prior to the irradiation of charged particles. As a result, a variation in a depth direction of a resistivity of the semiconductor substrate increases, making a rise in leakage current or a drop in a breakdown voltage of the semiconductor device more likely to occur.

### Solution to Technical Problem

CANCELLED

CANCELLED

CANCELLED

A method of manufacturing a semiconductor device is provided. More specifically, the present description may provide a method of manufacturing a semiconductor device, the semiconductor device including a first conductivity type drift layer formed in a semiconductor substrate, and a second conductivity type body layer formed on an upper surface of the semiconductor substrate and located on an upper surface side of the drift layer, wherein the drift layer comprises a lifetime control region having a crystal defect density equal to or higher than h/2, where h is a maximum value of a crystal defect density of the drift layer that varies in a depth direction of the semiconductor substrate. The method of manufacturing a semiconductor device comprises manufacturing the drift layer. The manufacturing the drift layer comprises forming a first conductivity type pre-drift layer including a first resistance layer and a second resistance layer, a resistivity of the second resistance layer being lower than a resistivity of the first resistance layer, and irradiating charged particles to the pre-drift layer such that at least a part of the lifetime control region is included in the second resistance layer.

In the method of manufacturing a semiconductor device described above, the first resistance layer includes a third resistance layer and a fourth resistance layer having a lower resistivity than the third resistance layer. In this case the second resistance layer is formed between the third resistance layer and the fourth resistance layer in the forming the pre-drift layer, and the charged particles are irradiated to the pre-drift layer from a fourth resistance layer side in the irradiating the charged particles.

The second resistance layer may be formed by an epitaxy.

### BRIEF DESCRIPTION OF DRAWINGS

FIG. 1 is a cross-sectional view of a semiconductor device according to a first embodiment.
FIG. 2 is a diagram showing resistivity values before and after crystal defect formation of the semiconductor device according to the first embodiment.
FIG. 3 is a diagram showing resistivity values before and after crystal defect formation of a conventional semiconductor device.
FIG. 4 is a diagram explaining a method of manufacturing the semiconductor device according to the first embodiment.
FIG. 5 is a diagram explaining the method of manufacturing the semiconductor device according to the first embodiment.
FIG. 6 is a diagram explaining the method of manufacturing the semiconductor device according to the first embodiment.
FIG. 7 is a diagram explaining the method of manufacturing the semiconductor device according to the first embodiment.
FIG. 8 is a diagram explaining the method of manufacturing the semiconductor device according to the first embodiment.
FIG. 9 is a diagram explaining a method of manufacturing a semiconductor device according to a modification.
FIG. 10 is a diagram explaining a method of manufacturing the semiconductor device according to a second embodiment.
FIG. 11 is a diagram explaining the method of manufacturing the semiconductor device according to the second embodiment.
FIG. 12 is a diagram explaining the method of manufacturing the semiconductor device according to the second embodiment.
FIG. 13 is a cross-sectional view of a semiconductor device according to a third embodiment.
FIG. 14 is a diagram showing resistivity values before and after crystal defect formation of the semiconductor device according to the third embodiment.

### DETAILED DESCRIPTION OF INVENTION

In a semiconductor device and a method of manufacturing the semiconductor device disclosed in the present description, a first resistance layer may be a single layer with a resistivity within a predetermined range, or may be a plurality of layers in which resistivities of the layers differ from each other. According to the present invention the first resistance layer includes a third resistance layer and a fourth resistance layer having a lower resistivity than the third resistance layer. In this case a second resistance layer is formed between the third resistance layer and the fourth resistance layer in forming a pre-drift layer, and charged particles are irradiated to the pre-drift layer from a fourth resistance layer side in irradiating the charged particles.

In the semiconductor device and the method of manufacturing the semiconductor device disclosed in the present description, the second resistance layer may include a constant resistance region having a resistivity that is constant in a depth direction, and the resistivity of the constant resistance region may be a minimum value of a resistivity of the second resistance layer. In the forming a pre-drift layer, the constant resistance region with the resistivity that is minimum in a depth direction and constant in the depth direction may be formed in a part of the second resistance layer. The constant resistance region can be formed by an epitaxy. In this case, the second resistance layer is favorably formed by an epitaxy. A resistivity distribution (a distribution in the depth direction of a semiconductor substrate) of the second resistance layer prior to the irradiation of charged particles is favorably a distribution having a minimum value and, more favorably, a distribution having a curved profile with a peak.

A lifetime control region has a peak of crystal defect density formed by irradiating charged particles. Favorably, a low resistance region in which the resistivity of the second resistance layer is equal to or lower than MN+(MX-MN)/2, where MX is a maximum value and MN is a minimum value of the resistivity of the second resistance layer in the depth direction, overlaps at least a part of the lifetime control region. Particularly favorably, in the irradiating the charged particles, the charged particles are irradiated so that the peak of crystal defect density is formed in the second resistance layer. In other words, favorably, irradiation is performed so that the charged particles stop inside the second resistance layer.

In the semiconductor device according to the present application, the lifetime control region with a high crystal defect density need only be formed by irradiating charged particles to the drift layer. For example, the semiconductor device may be a diode, an IGBT, or an RC-IGBT in which an IGBT and a free wheeling diode are formed on a same semiconductor substrate.

When the semiconductor device is a diode, a first conductivity type semiconductor layer which has a higher density of first conductivity type impurities than a drift layer is formed on a lower surface of the semiconductor substrate (a lower surface side of the drift layer). The first conductivity type semiconductor layer and a body layer respectively function as a cathode and an anode of the diode.

When the semiconductor device is an IGBT, a collector layer is formed on the lower surface of the semiconductor substrate (the lower surface side of the drift layer). The body layer is formed on an upper surface of the semiconductor substrate (an upper surface side of the drift layer). An emitter layer is formed in a part of an upper surface of the body layer. The body layer and the emitter layer are exposed at the upper surface of the semiconductor substrate. An insulated gate that is in contact with the body layer at a portion of the body layer that isolates the emitter layer and the drift layer from each other is formed on the upper surface side of the semiconductor substrate.

When the semiconductor device is an RC-IGBT in which an IGBT and a free wheeling diode are formed on a same semiconductor substrate, a collector layer or a cathode layer is formed on the lower surface of the semiconductor substrate (the lower surface side of the drift layer). The body layer is formed on the upper surface of the semiconductor substrate (the upper surface side of the drift layer). The emitter layer is formed in a part of the upper surface of the body layer. The body layer and the emitter layer are exposed at the upper surface of the semiconductor substrate. A gate electrode that is in contact with the body layer at a portion of the body layer that isolates the emitter layer and the drift layer from each other is formed on the upper surface side of the semiconductor substrate. The RC-IGBT may be a semiconductor device comprising a diode region in which a diode element is formed and an IGBT region in which an IGBT element is formed, and in which the diode region and the IGBT region are separated from each other. Alternatively, the RC-IGBT may be a semiconductor device in which the upper surface side of the semiconductor substrate shares a same structure, the lower surface side of the semiconductor substrate is structured as the collector layer or the cathode layer, and the diode element and the IGBT element coexist.

### [First embodiment]

### (Semiconductor device)

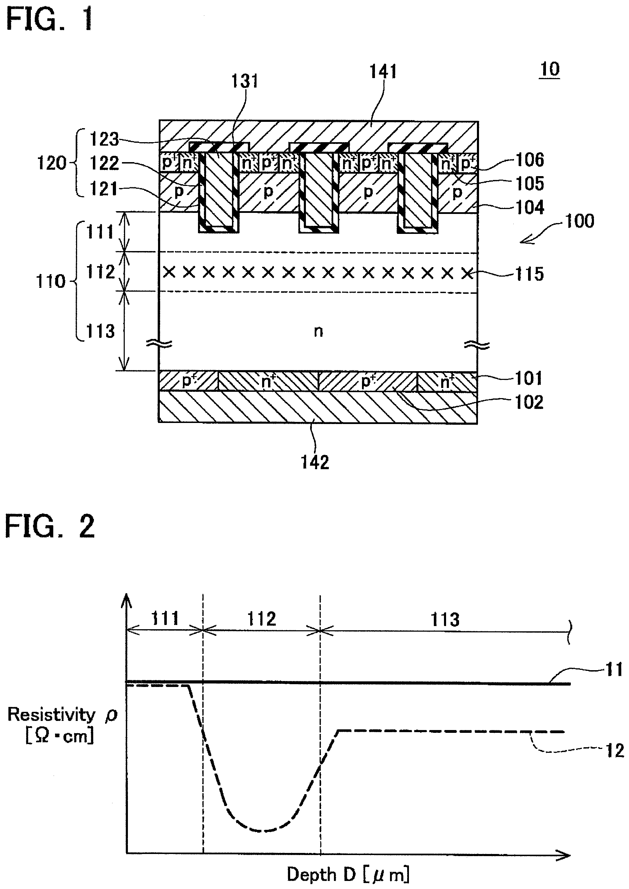

A semiconductor device 10 shown in FIG. 1 is an RC-IGBT in which an IGBT and a free wheeling diode are formed on a same semiconductor substrate 100.

The semiconductor device 10 comprises the semiconductor substrate 100, insulated gates 120 and upper surface insulating films 131 formed on an upper surface side of the semiconductor substrate 100, an upper surface electrode 141 in contact with the upper surface of the semiconductor substrate 100, and a lower surface electrode 142 in contact with a lower surface of the semiconductor substrate 100.

The semiconductor substrate 100 comprises an n type drift layer 110 and a p type low impurity body layer 104. n⁺ type cathode layers 101 and p⁺ type collector layers 102 are formed on a lower surface side of the drift layer 110. The cathode layers 101 and the collector layers 102 are adjacent to each other and are exposed at the lower surface of the semiconductor substrate 100, and are in contact with the lower surface electrode 142. n⁺ type emitter layers 105 and p⁺ type high impurity body layers 106 are formed on an upper surface side of the low impurity body layer 104. The term "n⁺ type" indicates that a density of n type impurities of the cathode layers 101 and a density of the emitter layers 105 are higher than a density of n type impurities of the drift layer 110. In a similar manner, the term "p⁺ type" indicates that a density of p type impurities of the collector layers 102 and a density of the high impurity body layers 106 are higher than a density of p type impurities of the low impurity body layer 104. The insulated gate 120 comprises a trench 121, a gate insulating film 122 formed on an inner wall of the trench 121, and an gate electrode 123 which is covered by the gate insulating film 122 and which fills an inside of the trench 121. The insulated gates 120 are in contact with the low impurity body layer 104 of a portion that isolates the emitter layers 105 and the drift layer 110 from each other. The emitter layers 105 and the high impurity body layers 106 are in contact with the upper surface electrode 141. The gate electrodes 123 are isolated from the upper surface electrode 141 by the upper surface insulating films 131.

The drift layer 110 is a laminate of, starting from the upper surface side of the semiconductor substrate 100, a first drift layer 111, a second drift layer 112, and a third drift layer 113. A lifetime control region 115 is formed in the second drift layer 112. The lifetime control region 115 is a region having a crystal defect density that is equal to or higher than h/2, where h is a maximum value of a crystal defect density of the drift layer 110 that varies in a depth direction of the semiconductor substrate 100. A peak of crystal defect density is located in the second drift layer 112. If ρ(1) denotes a resistivity of the first drift layer 111, ρ(2) denotes a resistivity of the second drift layer 112, and ρ(3) denotes a resistivity of the third drift layer 113, then ρ(1), ρ(2), and ρ(3) are approximately equal to each other (ρ(1) ≅ ρ(2) ≅ ρ(3)). A resistivity of the drift layer 110 is approximately constant in the depth direction of the semiconductor substrate 100. Moreover, a thickness of the third drift layer 113 is greater than a thickness of the first drift layer 111 and a thickness of the second drift layer 112, and a distance between the peak of crystal defect density of the lifetime control region 115 and an upper surface of the drift layer 110 (an interface between the drift layer 110 and the body layer 104) is significantly shorter than a distance between the peak of crystal defect density of the lifetime control region 115 and a lower surface of the drift layer 110 (an interface between the drift layer 110 and the cathode layer 101 and the collector layer 102).

FIG. 2 is a diagram showing the resistivity p of the drift layer 110 of the semiconductor device 10 as well as the resistivity of a drift layer prior to crystal defect formation (a pre-drift layer). A solid line 11 represents a relationship between the resistivity p of the drift layer 110 and a depth D of the drift layer 110, and a dashed line 12 represents a relationship between the resistivity ρ of the pre-drift layer and a depth D of the pre-drift layer. Reference numerals 111 to 113 denote positions of the first drift layer 111, the second drift layer 112, and the third drift layer 113 in the depth direction.

As shown in FIG. 2, in the pre-drift layer, a resistivity ρ(P1) of a layer located in the first drift layer 111 (referred to as a first pre-drift layer) and a resistivity ρ(P3) of a layer located in the third drift layer 113 (referred to as a third pre-drift layer) are approximately constant and are higher than a resistivity ρ(P2) of a layer located in the second drift layer 112 (referred to as a second pre-drift layer). Furthermore, the resistivity ρ(P1) is higher than the resistivity ρ(P3) (ρ(P1) > ρ(P3) > ρ(P2)). In other words, the first pre-drift layer and the third pre-drift layer correspond to a first resistance layer, and the second pre-drift layer corresponds to a second resistance layer with a resistivity that is lower than a resistivity of the first resistance layer. The first pre-drift layer corresponds to a third resistance layer, and the third pre-drift layer corresponds to a fourth resistance layer with a resistivity that is lower than a resistivity of the third resistance layer. Moreover, a resistivity distribution of the second pre-drift layer prior to the irradiation of charged particles is favorably a distribution having a minimum value such as that represented by the dashed line 12 and, more favorably, a distribution having a curved profile with a peak. A density distribution of crystal defects formed by irradiating charged particles has a curved profile with a maximum value peak in a depth direction of the semiconductor device. When the resistivity distribution of the second pre-drift layer has the curved profile with the minimum value peak, an effect of mitigating a decline in the resistivity of the second pre-drift layer due to crystal defects can be obtained efficiently, and a variation of the resistivity of the second drift layer in the depth direction can be reduced.

The peak of crystal defect density is formed in the second pre-drift layer by irradiating charged particles to the pre-drift layer from the lower surface side of the semiconductor substrate (a side of the third pre-drift layer) so that the charged particles pass through the third pre-drift layer and stop inside the second pre-drift layer. Low density crystal defects are also formed in the third pre-drift layer that is a layer through which the charged particles have passed (the third resistance layer). On the other hand, crystal defects are not formed in the first pre-drift layer which is beyond a reach of the crystal defects. The crystal defect density has a distribution in the depth direction of the semiconductor substrate that is shaped like the dashed line 12 inverted vertically. The higher the density of the crystal defects formed by the irradiation of charged particles, the greater an increase in the resistivity compared to prior to the crystal defect formation. A resistivity Δρ that rises due to the formation of the crystal defects has a distribution in the depth direction of the semiconductor substrate that is shaped like the dashed line 12 inverted vertically in a similar manner to the crystal defect density distribution.

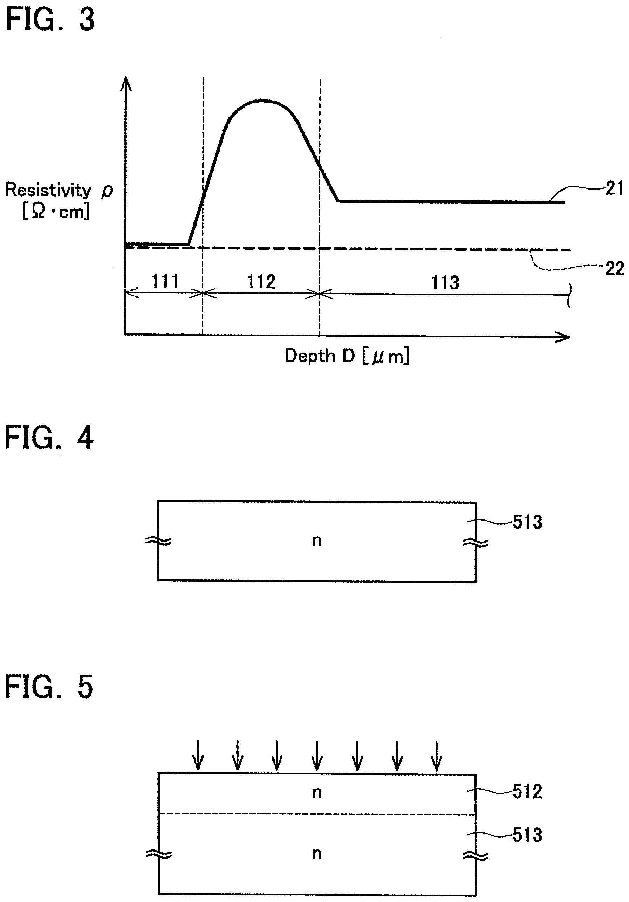

FIG. 3 illustrates a distribution of a resistivity ρ of a pre-drift layer and a drift layer of a conventional semiconductor device. Since the conventional semiconductor device and the semiconductor device 10 according to the first embodiment only differ from each other in resistivity distributions in a depth direction of a drift layer of a pre-drift layer and a drift layer, a description of a specific structure of the conventional semiconductor device will be omitted. A solid line 21 represents a relationship between a resistivity ρ and a depth D of a conventional drift layer, and a dashed line 22 represents a relationship between a resistivity ρ and a depth D of a conventional pre-drift layer. When the resistivity of the pre-drift layer is approximately constant in the depth direction as represented by the dashed line 22, forming a peak of crystal defect density at a position in the second pre-drift layer results in the resistivity of the drift layer having a distribution in the depth direction as represented by the solid line 21.

When the resistivity of the drift layer has the distribution that varies significantly in the depth direction as represented by the solid line 21, an effective carrier density of the drift layer declines during IGBT operation, enabling a depletion layer to spread more easily. As a result, the depletion layer may readily reach the collector layer at a lower surface to cause a decline in a breakdown voltage and an increase in a leakage current of the semiconductor device. Methods of suppressing the decline in the breakdown voltage include increasing a thickness of the semiconductor substrate and reducing the resistivity of the entire pre-drift layer. However, making the semiconductor substrate thicker increases a resistance of the entire semiconductor device and increases a risk of poor conduction. Reducing the resistivity of the entire pre-drift layer results in a greater characteristic variation of a diode.

In contrast, with the semiconductor device 10 according to the first embodiment, as shown in FIG. 2, the resistivity of the pre-drift layer is distributed so as to cancel out the resistivity Δρ that increases when the charged particles are irradiated. Therefore, the resistivity of the drift layer 110 that is obtained by forming the crystal defects can be set approximately constant in the depth direction. With the semiconductor device 10, the variation of the resistivity of the drift layer in the depth direction is mitigated compared to the conventional semiconductor device. Therefore, the semiconductor device comprising the lifetime control region can suppress the decline in the breakdown voltage and the increase in the leakage current and, at the same time, suppress the poor conduction by adopting a thinner semiconductor substrate. In addition, with the semiconductor device comprising a diode, the characteristic variation of the diode can be suppressed.

### (Method of manufacturing semiconductor device)

Steps of manufacturing the drift layer of the semiconductor device 10 will now be described by way of example. While a description of other components of the semiconductor device 10 will be omitted, it should be obvious to those skilled in the art that the other components of the semiconductor device 10 can be manufactured by known, conventional manufacturing methods.

### (Pre-drift layer forming step)

FIGS. 4 to 6 show forming of a pre-drift layer 510. As shown in FIG. 4, an n type semiconductor wafer is prepared as a third pre-drift layer 513. A thickness of the n type wafer shown in FIG. 4 is approximately equal to a thickness of the third pre-drift layer 513.

Next, as shown in FIG. 5, a second pre-drift layer 512 that is an epitaxial layer is formed on an upper surface of the third pre-drift layer 513 by epitaxy. The higher an impurity density, the lower a resistivity of the pre-drift layer. Therefore, by adjusting an impurity density of the second pre-drift layer 512, the resistivity of the second pre-drift layer 512 can be adjusted. The second pre-drift layer 512 is formed by performing the epitaxy in the presence of an n type dopant gas adjusted so that a density of n type impurities in the second pre-drift layer 512 becomes higher than a density of n type impurities in the third pre-drift layer 513 and a silicon deposition gas.

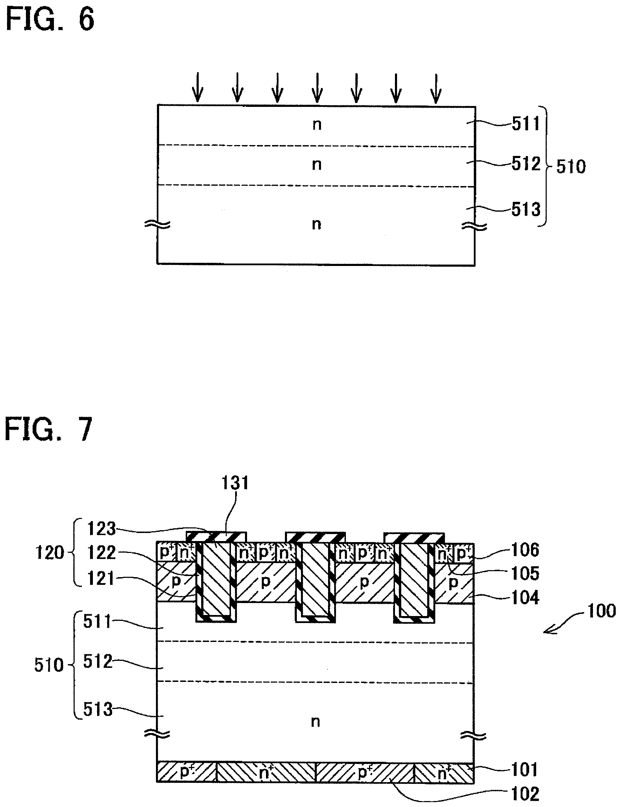

Next, as shown in FIG. 6, a first pre-drift layer 511 that is an epitaxial layer is formed on an upper surface of the second pre-drift layer 512 by the epitaxy. The first pre-drift layer 511 is formed by performing the epitaxy in the presence of an n type dopant gas adjusted so that a density of n type impurities in the first pre-drift layer 511 becomes lower than a density of n type impurities in the second pre-drift layer 512 and the third pre-drift layer 513 and the silicon deposition gas. Subsequently, annealing such as a heat treatment is performed to activate n type dopants. As a result, a pre-drift layer 510 can be manufactured which is adjusted so that the resistivity ρ(P1) of the first pre-drift layer 511, the resistivity ρ(P2) of the second pre-drift layer 512, and the resistivity ρ(P3) of the third pre-drift layer 513 have the relationship satisfying ρ(P1) > ρ(P3) > ρ(P2).

### (Charged particle irradiating step)

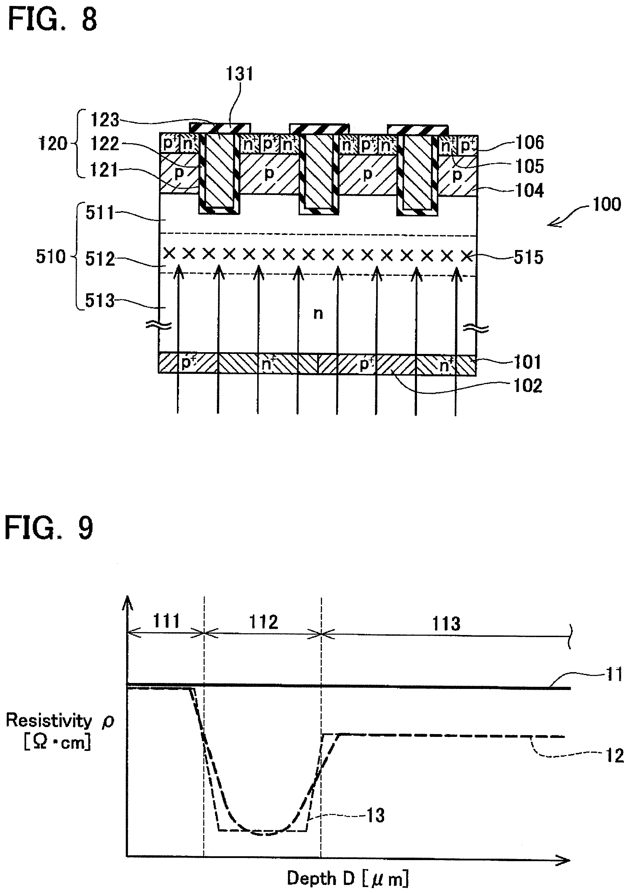

FIGS. 7 and 8 show a step of irradiating the charged particles. FIG. 7 shows a state after forming the pre-drift layer 510 and further forming structures on the upper surface side and the lower surface side of the semiconductor substrate 100 with the exception of the upper surface electrode 141 and the lower surface electrode 142.

In the step of irradiating the charged particles, the charged particles are irradiated from the lower surface side of the semiconductor substrate 100. While the irradiated charged particles are not particularly limited, helium (⁴He, ³He) ions and hydrogen (¹H, ²H, ³H) ions are particularly favorable. The charged particles irradiated from the lower surface side of the semiconductor substrate 100 pass through the third pre-drift layer 513 and stop inside the second pre-drift layer 512. The peak of crystal defect density and high density crystal defects are formed in the second pre-drift layer 512 in which the charged particles stop. The low density crystal defects are also formed in the third pre-drift layer 513 through which the charged particles pass. Consequently, the first pre-drift layer 511, the second pre-drift layer 512, and the third pre-drift layer 513 respectively become the first drift layer 111, the second drift layer 112, and the third drift layer 113 as shown in FIG. 1. If X(1) denotes the density of the crystal defects formed in the first pre-drift layer 511 by irradiating charged particles, X(2) denotes the density of the crystal defects formed in the second pre-drift layer 512 by irradiating the charged particles, and X(3) denotes the density of the crystal defects formed in the third pre-drift layer 513 by irradiating the charged particles, then X(2) > X(3) > X(1) is true. The higher the density of the crystal defects formed by irradiating the charged particles, the greater the increase in the resistivity of the drift layer due to the irradiation of charged particles. If Δρ(1) = ρ(1) - ρ(P1) denotes a difference in the resistivity between the first pre-drift layer 511 and the first drift layer 111, Δρ(2) = ρ(2) - ρ(P2) denotes a difference in the resistivity between the second pre-drift layer 512 and the second drift layer 112, and Δρ(3) = ρ(3) - ρ(P3) denotes a difference in the resistivity between the third pre-drift layer 513 and the third drift layer 113, then Δρ(1) < Δρ(3) < Δρ(2) is true. In this case, since the resistivities of the respective pre-drift layers satisfy ρ(P1) > ρ(P3) > ρ(P2), the difference between the resistivities of the respective drift layers obtained after irradiating the charged particles can be reduced. In the present embodiment, the respective resistivities ρ(P1), ρ(P2), and ρ(P3) of the pre-drift layers are adjusted in advance so that the resistivities of the respective drift layers after irradiating the charged particles satisfy ρ(1) ≅ ρ(2) ≅ ρ(3).

As described above, with the method of manufacturing the semiconductor device according to the present embodiment, the first pre-drift layer 511 that is the third resistance layer, the third pre-drift layer 513 that is the fourth resistance layer, and the second pre-drift layer 512 that is the second resistance layer are formed in the step of forming of the pre-drift layer 510. In the subsequently performed step of irradiating the charged particles, the charged particles are irradiated to the pre-drift layer 510 so that at least a part of the lifetime control region 115 is included in the second pre-drift layer 512. The charged particles pass through the third pre-drift layer 513 and stop inside the second pre-drift layer 512. The crystal defects are formed at a high density in the second pre-drift layer 512 and at a low density in the third pre-drift layer 513. The peak of crystal defect density is located in the second pre-drift layer 512 in which the charged particles stop. Since the resistivity of the second pre-drift layer 512 is lower than the resistivity of the first pre-drift layer 511 and the resistivity of the third pre-drift layer 513, the resistivity of the second pre-drift layer 512 becoming excessively high due to the formation of the crystal defects in high density can be prevented. Since the resistivity of the third pre-drift layer 513 through which the charged particles pass is lower than the resistivity of the first pre-drift layer 511 through which the charged particles do not pass, the increase in the resistivity of the third pre-drift layer 513 due to the formation of the crystal defects in low density in the third pre-drift layer 513 can be prevented. According to the present embodiment, the semiconductor device 10 in which the variation of the resistivity of the drift layer 110 in the depth direction is mitigated compared to the conventional devices can be readily manufactured. In addition, since the second pre-drift layer 512 is formed as the epitaxial layer, a density and a variation of non-conductive impurities (for example, carbon and oxygen) in the second pre-drift layer 512 can be reduced. As a result, when the lifetime control region 115 is formed by irradiating the charged particles, the variation in the formed crystal defects attributable to the non-conductive impurities declines and a characteristic variation of the semiconductor device 10 can be reduced. Furthermore, since a semiconductor wafer can be used as the thickest third pre-drift layer 513, the semiconductor device 10 can be made thinner and, at the same time, manufacturing steps of the semiconductor device 10 can be simplified. As a result, both a material cost and a manufacturing cost of the semiconductor device 10 can be reduced.

### (Modification)

In the embodiment described above, the second pre-drift layer 512 may be formed so as to include a constant resistance region in which the resistivity is constant. In other words, prior to annealing, the pre-drift layer 510 may have a resistivity distribution such as that represented by a thin dashed line 13 in FIG. 9. Prior to annealing, the resistivity of the second pre-drift layer 512 may include the constant resistance region in which the resistivity is constant such as represented by the thin dashed line 13. Furthermore, in this case, the resistivity of the constant resistance region may be set equal to a minimum value of the resistivity of the second pre-drift layer 512. Moreover, when subjected to annealing, the pre-drift layer 510 having the resistivity distribution represented by the thin dashed line 13 in FIG. 9 is transformed to the pre-drift layer 510 having the curved resistivity distribution represented by the dashed line 12 in FIG. 9. With the aforementioned method of forming the second pre-drift layer 512 by an epitaxy, the second pre-drift layer 512 having the constant resistance region with the constant resistivity such as represented by the thin dashed line 13 can be readily formed.

### [Second embodiment]

In the second embodiment, the pre-drift layer forming step of the semiconductor device 10 described in the first embodiment will be described by way of another example. Moreover, in a similar manner to the first embodiment, while a description of other components of the semiconductor device 10 will be omitted, it should be obvious to those skilled in the art that the other components of the semiconductor device 10 can be manufactured by known, conventional manufacturing methods. Furthermore, since a charged particle irradiating step is similar to that of the first embodiment, a description thereof will be omitted.

### (Pre-drift layer forming step)

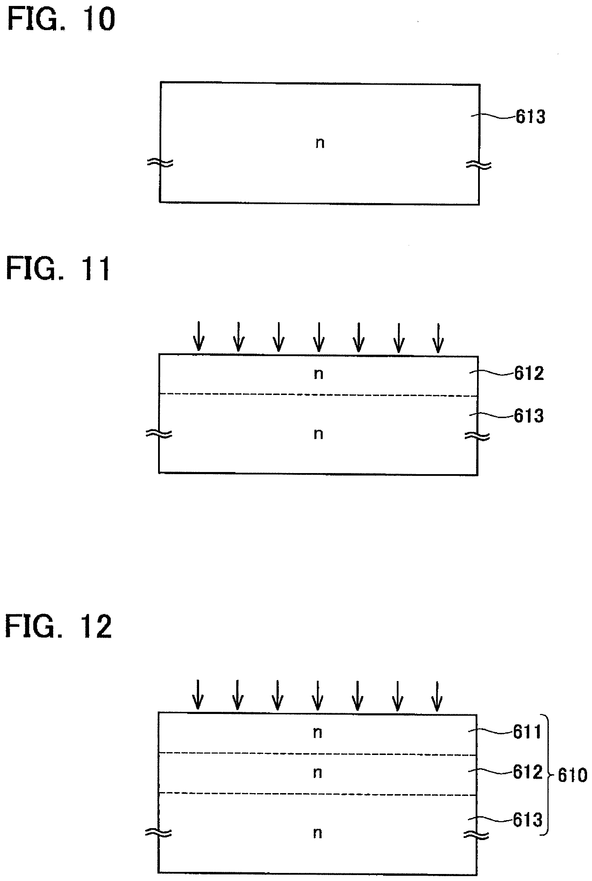

FIGS. 10 to 12 show a step of forming a pre-drift layer 610. As shown in FIG. 10, an n type semiconductor wafer is prepared as a third pre-drift layer 613. Moreover, a thickness of the n type semiconductor wafer shown in FIG. 10 is thicker than a thickness of the third pre-drift layer 613 after the pre-drift layer forming step is completed.

Next, as shown in FIG. 11, n type dopants are irradiated onto a surface layer of the third pre-drift layer 613 to form a second pre-drift layer 612 that has a higher density of n type impurities than the third pre-drift layer 613. The thickness of the third pre-drift layer 613 is reduced by an amount corresponding to a thickness of the second pre-drift layer 612.

Subsequently, as shown in FIG. 12, a first pre-drift layer 611 that is an epitaxial layer is formed on an upper surface of the second pre-drift layer 612 by epitaxy. The first pre-drift layer 611 is formed by performing the epitaxy in the presence of an n type dopant gas adjusted so that a density of n type impurities in the first pre-drift layer 611 becomes lower than a density of n type impurities in the second pre-drift layer 612 and the third pre-drift layer 613 and a silicon deposition gas. Subsequently, annealing such as a heat treatment is performed to activate the n type dopants. As a result, in a similar manner to the first embodiment, a pre-drift layer 610 can be manufactured which is adjusted so that a resistivity ρ(P1) of the first pre-drift layer 611, a resistivity ρ(P2) of the second pre-drift layer 612, and a resistivity ρ(P3) of the third pre-drift layer 613 have a relationship satisfying ρ(P1) > ρ(P3) > ρ(P2). In the second embodiment, since the second pre-drift layer 612 is not formed as an epitaxial layer, both a material cost and a manufacturing cost can be further reduced in comparison to the method described in the first embodiment. Subsequently, using the pre-drift layer 610 in place of the pre-drift layer 510 as shown in FIG. 7, structures of an upper surface side and a lower surface side of a semiconductor substrate 100 is formed with the exception of an upper surface electrode 141 and a lower surface electrode 142 in a similar manner to the first embodiment to perform a charged particle irradiating step. As a result, the semiconductor device 10 can be manufactured.

### [Third embodiment]

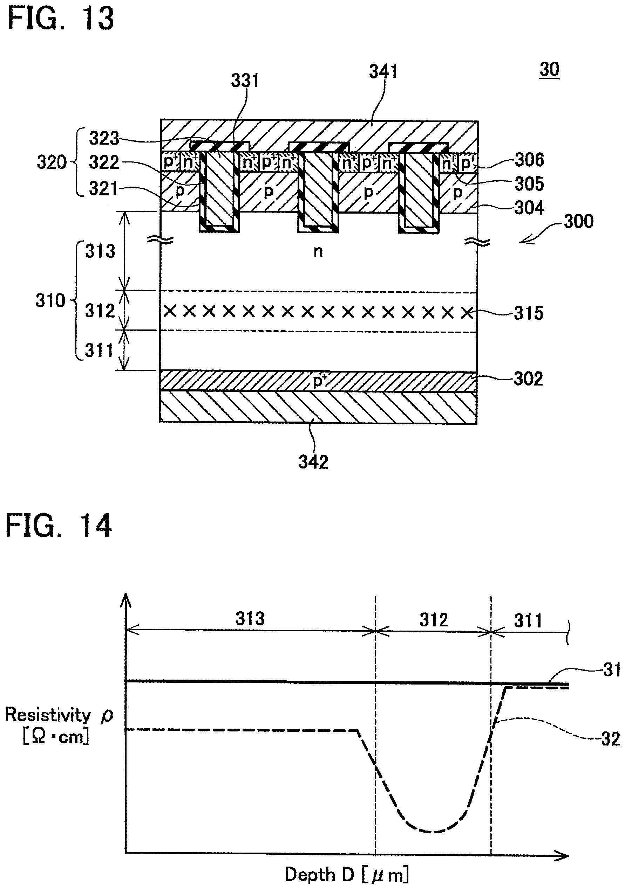

In the third embodiment, a case will be described in which an IGBT is exemplified as a semiconductor device 30 and charged particles are irradiated from an upper surface side of a semiconductor substrate to form crystal defects. As shown in FIG. 13, the semiconductor device 30 comprises a semiconductor substrate 300, insulated gates 320 and upper surface insulating filma 331 formed on an upper surface side of the semiconductor substrate 300, an upper surface electrode 341 in contact with the upper surface of the semiconductor substrate 300, and a lower surface electrode 342 in contact with a lower surface of the semiconductor substrate 300. The semiconductor substrate 300 comprises an n type drift layer 310 and a p type low impurity body layer 304. A p⁺ type collector layer 302 is formed on a lower surface side of the drift layer 310. The collector layer 302 is exposed at the lower surface of the semiconductor substrate 300 and is in contact with the lower surface electrode 342.

The drift layer 310 is a laminate of, starting from the lower surface side of the semiconductor substrate 300, a first drift layer 311, a second drift layer 312, and a third drift layer 313. A lifetime control region 315 is formed in the second drift layer 312. The lifetime control region 315 is a region having a crystal defect density that is equal to or higher than h/2, where h is a maximum value of a crystal defect density of the drift layer 310 that varies in a depth direction of the semiconductor substrate 300. A peak of the crystal defect density is located in the second drift layer 312. If ρ(1) denotes a resistivity of the first drift layer 311, ρ(2) denotes a resistivity of the second drift layer 312, and ρ(3) denotes a resistivity of the third drift layer 313, then ρ(1), ρ(2), and ρ(3) are approximately equal to each other (ρ(1) ≅ ρ(2) ≅ ρ(3)). A resistivity of the drift layer 310 is approximately constant in a depth direction of the semiconductor substrate 300. Moreover, a thickness of the third drift layer 313 is greater than a thickness of the first drift layer 311 and a thickness of the second drift layer 312, and a distance between the peak of the crystal defect density of the lifetime control region 315 and a lower surface of the drift layer 310 (an interface between the drift layer 310 and the collector layer 302) is significantly shorter than a distance between the peak of the crystal defect density of the lifetime control region 315 and an upper surface of the drift layer 310 (an interface between the drift layer 310 and the body layer 304). Since other components are similar to those of the semiconductor device 10 shown in FIG. 1, overlapping descriptions will be omitted by replacing the reference numerals in the hundreds with those in the three-hundreds.

FIG. 14 is a diagram showing a resistivity ρ of the drift layer 310 of the semiconductor device 30 as well as a resistivity of a drift layer prior to crystal defect formation (a pre-drift layer). A solid line 31 represents a relationship between a resistivity ρ of the drift layer 310 and a depth D of the drift layer 310, and a dashed line 32 represents a relationship between a resistivity ρ of the pre-drift layer and a depth D of the pre-drift layer. Reference numerals 311 to 313 denote positions of the first drift layer 311, the second drift layer 312, and the third drift layer 313 in a depth direction.

As shown in FIG. 14, in the pre-drift layer, a resistivity ρ(P1) of a layer located in the first drift layer 311 (referred to as a first pre-drift layer) and a resistivity ρ(P3) of a layer located in the third drift layer 313 (referred to as a third pre-drift layer) are approximately constant and are higher than a resistivity ρ(P2) of a layer located in the second drift layer 312 (referred to as a second pre-drift layer). Furthermore, the resistivity ρ(P1) is higher than the resistivity ρ(P3) (ρ(P1) > ρ(P3) > ρ(P2)). In other words, the first pre-drift layer and the third pre-drift layer correspond to a first resistance layer, and the second pre-drift layer corresponds to a second resistance layer with a resistivity that is lower than a resistivity of the first resistance layer. The first pre-drift layer corresponds to a third resistance layer, and the third pre-drift layer corresponds to a fourth resistance layer with a resistivity that is lower than a resistivity of the third resistance layer.

A peak of crystal defect density is formed in the second pre-drift layer by irradiating charged particles to the pre-drift layer from the upper surface side of the semiconductor substrate (a side of the third pre-drift layer) so that the charged particles pass through the third pre-drift layer and stop inside the second pre-drift layer. A low density crystal defects are also formed in the third pre-drift layer that is a layer through which the charged particles have passed (the fourth resistance layer). On the other hand, crystal defects are not formed in the first pre-drift layer which is beyond a reach of the charged particles. The crystal defect density has a distribution in a depth direction of the semiconductor substrate that is shaped like the dashed line 32 inverted vertically. The higher a density of crystal defects formed by the irradiation of charged particles, the greater an increase in resistivity compared to prior to crystal defect formation. A resistivity Δρ that rises due to a formation of crystal defects has a distribution in a depth direction of the semiconductor substrate that is shaped like the dashed line 32 inverted vertically in a similar manner to the crystal defect density distribution.

As a method of manufacturing the semiconductor device 30, the manufacturing methods described in the first and second embodiments can be applied. The semiconductor device 30 can be readily manufactured by using an n type semiconductor wafer as the third pre-drift layer and by forming the first pre-drift layer and the second pre-drift layer using the method described in the first or second embodiment, and irradiating charged particles from the upper surface side of the semiconductor substrate.

While a case in which a semiconductor wafer is used as a part of a drift layer has been exemplified in the manufacturing methods described in the embodiments, the present invention is not limited thereto. For example, with the semiconductor device 30, a semiconductor wafer can be used as a collector layer and a drift layer can be manufactured by an epitaxy. Furthermore, while an RC-IGBT and an IGBT have been exemplified and described in the embodiments, the present invention is not limited thereto. For example, the constructions and manufacturing methods according to the first to third embodiments can also be applied in a case in which the semiconductor device is a diode.

While embodiments of the present invention have been described in detail, such embodiments are merely illustrative and are not intended to limit the scope of claims. Techniques described in the scope of claims include various modifications and changes made to the specific examples illustrated above.

It is to be understood that the technical elements described in the present description and the drawings exhibit technical usefulness solely or in various combinations thereof.

## Claims

1. A method of manufacturing a semiconductor device (10), the semiconductor device including a first conductivity type drift layer (110) formed in a semiconductor substrate (10); and a second conductivity type body layer (104) formed on an upper surface of the semiconductor substrate (10) and located on an upper surface side of the drift layer, wherein the drift layer comprises a lifetime control region (115) having a crystal defect density equal to or higher than h/2, where h is a maximum value of a crystal defect density of the drift layer that varies in a depth direction, **characterized in that** the method comprises manufacturing the drift layer comprising:
forming a first conductivity type pre-drift layer (510,610,310)
including a first resistance layer (511,513,611,613,311,313) and a second resistance layer (512,612,312), a resistivity of the second resistance layer (512,612,312) being lower than a resistivity of the first resistance layer (511,513,611,613,311,313),
irradiating charged particles to the pre-drift layer (510,610,310) such that at least a part of the lifetime control region is included in the second resistance layer (512,612,312), the first resistance layer comprises a third resistance layer (511,611,311) and a fourth resistance layer (513,613,313)
having a lower resistivity than the third resistance layer (511), the second resistance layer (512,612,312) is formed between the third resistance layer (511,611,311) and the fourth resistance layer (513,613,313) in the forming the pre-drift layer (510,610,310), and the charged particles are irradiated from a fourth resistance layer side in the irradiating the charged particles.

2. The method of manufacturing a semiconductor device according to claim 1, wherein the second resistance layer (51,612,312) is formed by an epitaxy.

## Patentansprüche

1. Verfahren zum Herstellen einer Halbleitervorrichtung (10), wobei die Halbleitervorrichtung eine Driftschicht (110) eines ersten Leitfähigkeitstyps, die in einem Halbleitersubstrat (10) ausgebildet ist, und eine Körperschicht (104) eines zweiten Leitfähigkeitstyps, die auf einer oberen Oberfläche des Halbleitersubstrats (10) ausgebildet ist und sich auf einer oberen Oberflächenseite der Driftschicht befindet, beinhaltet, wobei die Driftschicht einen Lebensdauersteuerbereich (115) mit einer Kristalldefektdichte gleich oder höher als h/2 aufweist, wobei h ein Maximalwert einer Kristalldefektdichte der Driftschicht ist, die in einer Tiefenrichtung variiert,
**dadurch gekennzeichnet, dass** das Verfahren ein Herstellen der Driftschicht umfasst, umfassend:
Bilden einer Vordriftschicht von einem ersten Leitfähigkeitstyp (510, 610, 310), einschließlich einer ersten Widerstandsschicht (511, 513, 611, 613, 311, 313) und einer zweiten Widerstandsschicht (512, 612, 312), wobei eine Resistivität der zweiten Widerstandsschicht (512, 612, 312) niedriger als eine Resistivität der ersten Widerstandsschicht (511, 513, 611, 613, 311, 313) ist,
Bestrahlen der Vordriftschicht (510, 610, 310) mit geladenen Teilchen derart, dass mindestens ein Teil des Lebensdauersteuerbereichs in der zweiten Widerstandsschicht (512, 612, 312) enthalten ist, wobei die erste Widerstandsschicht eine dritte Widerstandsschicht (511, 611, 311) und eine vierte Widerstandsschicht (513, 613, 313) mit einer niedrigeren Resistivität als die dritte Widerstandsschicht (511) umfasst,
wobei die zweite Widerstandsschicht (512, 612, 312) zwischen der dritten Widerstandsschicht (511, 611, 311) und der vierten Widerstandsschicht (513, 613, 313) bei der Bildung der Vordriftschicht (510, 610, 310) ausgebildet wird, und
die geladenen Teilchen beim Bestrahlen mit den geladenen Teilchen von einer vierten Widerstandsschichtseite abgestrahlt werden.

2. Verfahren zum Herstellen einer Halbleitervorrichtung nach Anspruch 1, wobei die zweite Widerstandsschicht (51, 612, 312) durch eine Epitaxie gebildet wird.

## Revendications

1. Procédé de fabrication d'un dispositif semi-conducteur (10), le dispositif semi-conducteur comprenant une couche de migration d'un premier type de conductivité (110) formée dans un substrat de semi-conducteur (10) ; et une couche de corps d'un deuxième type de conductivité (104) formée sur une surface supérieure du substrat de semi-conducteur (10) et située sur un côté de surface supérieure de la couche de migration, selon lequel la couche de migration comporte une zone de commande de durée de vie (115) ayant une densité de défaut de cristal égale ou supérieure à h/2, où h est une valeur maximale d'une densité de défaut de cristal de la couche de migration qui varie dans une direction de profondeur,
**caractérisé en ce que** le procédé comprend la fabrication de la couche de migration comportant le fait de :
former une couche de pré-migration d'un premier type de conductivité (510, 610, 310) comprenant une première couche de résistance (511, 513, 611, 613, 311, 313) et une deuxième couche de résistance (512, 612, 312),
une résistivité de la deuxième couche de résistance (512, 612, 312) étant inférieure à une résistivité de la première couche de résistance (511, 513, 611, 613, 311, 313),
irradier des particules chargées sur la couche de pré-migration (510, 610, 310) de telle sorte que au moins une partie de la zone de commande de durée de vie est incluse dans la deuxième couche de résistance (512, 612, 312),
la première couche de résistance comporte une troisième couche de résistance (511, 611, 311) et une quatrième couche de résistance (513, 613, 313) ayant une résistivité plus faible que la troisième couche de résistance (511),
la deuxième couche de résistance (512, 612, 312) est formée entre la troisième couche de résistance (511, 611, 311) et la quatrième couche de résistance (513, 613, 313) dans la formation de la couche de pré-migration (510, 610, 310), et
les particules chargées sont irradiées depuis un côté de quatrième couche de résistance dans l'irradiation des particules chargées.

2. Procédé de fabrication d'un dispositif semi-conducteur selon la revendication 1, selon lequel la deuxième couche de résistance (51, 612, 312) est formée par une épitaxie.
